(19) **Europäisches Patentamt European Patent Office Office européen des brevets**

(11) **EP 3 583 696 B1**

(12) **FASCICULE DE BREVET EUROPEEN**

(45) Date de publication et mention de la délivrance du brevet:
**20.04.2022 Bulletin 2022/16**

(21) Numéro de dépôt: **17710998.0**

(22) Date de dépôt: **17.02.2017**

(51) Classification Internationale des Brevets (IPC):
**H03K 17/95** (2006.01)   **H03K 17/955** (2006.01)

(52) Classification Coopérative des Brevets (CPC):
**H03K 17/955; E05B 81/77; G07C 9/00174; H03K 17/954;** G07C 2209/08; G07C 2209/65; H03K 2017/9706; H03K 2217/94036; H03K 2217/96054; H03K 2217/960705

(86) Numéro de dépôt international:
**PCT/FR2017/050356**

(87) Numéro de publication internationale:
**WO 2018/150106 (23.08.2018 Gazette 2018/34)**

(54) **PROCÉDÉ DE DÉTECTION D'INTENTION DE VERROUILLAGE OU DE DÉVERROUILLAGE D'UNE PORTIÈRE DE VÉHICULE AUTOMOBILE PAR UN UTILISATEUR ET DISPOSITIF ASSOCIÉ**

**VERFAHREN ZUR ERKENNUNG EINER BENUTZERABSICHT ZUM VERRIEGELN ODER ENTRIEGELN EINER KRAFTFAHRZEUGTÜR UND ZUGEHÖRIGE VORRICHTUNG**

**METHOD FOR DETECTING A USER'S INTENTION TO LOCK OR UNLOCK A MOTOR VEHICLE DOOR AND ASSOCIATED DEVICE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**25.12.2019 Bulletin 2019/52**

(73) Titulaire: **Vitesco Technologies GmbH 93055 Regensburg (DE)**

(72) Inventeurs:
• **SPICK, Gabriel 31300 Toulouse (FR)**
• **GUIBBERT, Mickael CV32 5FP Leamington SPA (GB)**

(74) Mandataire: **Vitesco Technologies Postfach 12 02 82019 Taufkirchen (DE)**

(56) Documents cités:
**EP-A2- 2 595 120      FR-A1- 3 038 642 US-A1- 2011 043 227     US-A1- 2016 344 386**

**Description**

L'invention concerne un procédé de détection de présence d'un utilisateur et une poignée de portière de véhicule comprenant un dispositif de détection et le dispositif de détection associé.

De nos jours, les poignées de portières de véhicule sont équipées de dispositifs de détection de la présence d'un utilisateur. La détection de la présence d'un utilisateur couplée à la reconnaissance d'un badge électronique « main libre » de commande d'accès à distance, porté par cet utilisateur, permet le verrouillage et le déverrouillage à distance des ouvrants du véhicule. Ainsi lorsque l'utilisateur, portant le badge électronique correspondant et identifié par le véhicule souhaite déverrouiller le véhicule, il s'approche de la poignée ou touche la poignée de portière du véhicule et les ouvrants du véhicule sont alors automatiquement déverrouillés. En s'approchant ou en appuyant sur un endroit précis de la poignée de portière du véhicule, appelé « zone de déverrouillage », la portière (ou alternativement tous les ouvrants) est (sont) déverrouillée (déverrouillés) sans autre action de l'utilisateur. Inversement, lorsque l'utilisateur, portant toujours le badge nécessaire et identifié par le véhicule, souhaite verrouiller son véhicule, il ferme la portière de son véhicule et il s'approche ou appuie momentanément sur un autre endroit précis de la poignée, appelé « zone de verrouillage ». Ce geste permet de verrouiller automatiquement les ouvrants du véhicule.

Ces dispositifs de détection de présence comprennent généralement deux capteurs capacitifs, sous la forme de deux électrodes reliées électriquement à un circuit imprimé, intégrées dans la poignée de portière chacune dans une zone précise de verrouillage ou de déverrouillage. Généralement, une électrode est dédiée à chaque zone, c'est-à-dire une électrode est dédiée à la détection de l'approche et/ou du contact de la main de l'utilisateur dans la zone de verrouillage et une électrode est dédiée à la détection de l'approche et/ou du contact de la main de l'utilisateur dans la zone de déverrouillage.

Le dispositif de détection de présence comprend en outre une antenne radio fréquence, en général LF (abréviation anglaise pour « Low Frequency », Basse Fréquence). Le dispositif de détection est connecté au calculateur électronique du véhicule (ECU : abréviation anglaise pour « Electronic Control Unit ») et lui envoie un signal de détection de présence. Le calculateur électronique du véhicule a, au préalable, identifié l'utilisateur comme étant autorisé à accéder à ce véhicule, ou alternativement, suite à la réception de ce signal de détection de présence, il procède à cette identification. Pour cela, il envoie par l'intermédiaire de l'antenne radiofréquence, une demande d'identification au badge (ou à la télécommande) porté(e) par l'utilisateur. Ce badge envoie en réponse, par ondes RF (Radio Fréquence) son code d'identification vers le calculateur électronique du véhicule. Si le calculateur électronique reconnait le code d'identification comme celui autorisant l'accès au véhicule, il déclenche le verrouillage/déverrouillage de la portière (ou de tous les ouvrants). Si, en revanche, le calculateur électronique n'a pas reçu de code d'identification ou si le code d'identification reçu est erroné, le verrouillage ou déverrouillage ne se fait pas.

De tels véhicules sont donc équipés de poignées de portière comprenant un dispositif de détection comprenant lui-même une antenne radiofréquence, généralement basse fréquence et deux électrodes reliées à un microcontrôleur, intégré dans un circuit imprimé et alimenté en tension.

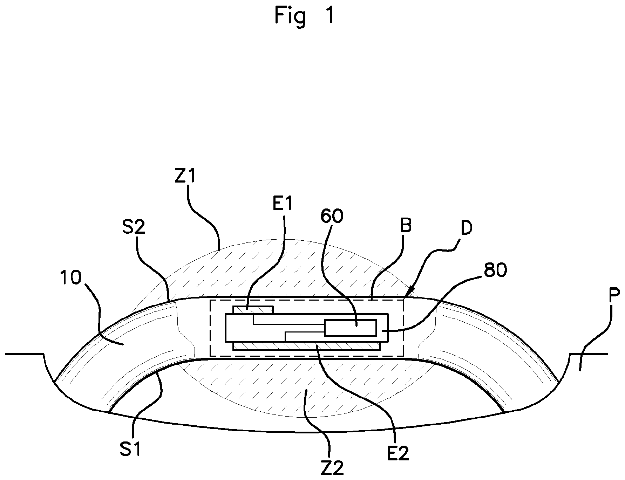

Dans un but purement explicatif, il sera considéré ici un dispositif de détection D comprenant deux électrodes, une électrode dédiée à la zone de déverrouillage et une électrode dédiée à la zone de verrouillage, lesdites deux électrodes étant reliées à un circuit imprimé comprenant un microcontrôleur, et une antenne LF. Un dispositif de détection D de l'art antérieur est décrit en regard de la **figure 1.**

A la **figure 1**, est représentée une poignée de portière 10 de véhicule automobile (véhicule non représenté) dans laquelle se trouve un dispositif de détection D de présence d'un utilisateur. Ladite poignée de portière 10 comprend une première surface extérieure S1 orientée en direction de la portière P et une deuxième surface extérieure S2, opposée à la première surface extérieure S1 et donc orientée du côté opposé au véhicule, plus précisément vers l'utilisateur (non représenté). Ce dispositif de détection D comprend une première électrode E2 de déverrouillage dont une face se situe à proximité de la première surface extérieure S1, une antenne LF (non représentée) dont une face se situe à proximité de la deuxième surface extérieure S2, une deuxième électrode E1 de verrouillage dont une face se situe à proximité de la deuxième surface extérieure S2, ainsi que des moyens de contrôle 60 . La première et la deuxième électrode E1, E2 sont reliées aux moyens de contrôle 60. Ces moyens de contrôle 60 mesurent la capacité aux bornes chaque première et deuxième électrode E1, E2 afin de détecter la présence (l'approche et/ou le contact) d'un utilisateur dans les zones de détection, c'est-à-dire dans une zone de verrouillage Z1 ou dans une zone de déverrouillage Z2 et sont par exemple constitués d'un microcontrôleur 60 intégré dans un circuit imprimé 80. L'antenne LF (non représentée) est, quant à elle, reliée à un calculateur électronique embarqué sur le véhicule (non représenté) du type BCM (« Body Controller Module », ou Module de contrôle châssis) qui gère les demandes d'identification émises par ladite antenne LF.

Cependant, ce dispositif de détection D de l'art antérieur présente des inconvénients majeurs.

En l'occurrence, la détection de l'approche d'un utilisateur par des capteurs capacitifs (première et deuxième électrode E1 et E2) n'est pas robuste et génère de fausses détections.

En particulier, dans certaines conditions environnementales, lorsque l'air ambiant est humide, ou lorsqu'il y a du sel sur les routes, qui se trouve projeté sur la carrosserie métallique du véhicule, il se crée un couplage capacitif entre les zones de détection (zone de verrouillage Z1 et zone de déverrouillage Z2) et les parties métalliques du véhicule, ce qui empêche toute détection de présence d'un utilisateur par les capteurs capacitifs.

De plus, les gouttes de pluie ou les flocons de neige sur la poignée de portière augmentent la valeur de la capacité mesurée par les capteurs capacitifs, déclenchant ainsi de fausses détections.

Et finalement, la détection par des capteurs capacitifs est incompatible avec des poignées recouvertes de peintures métalliques ou comprenant des surfaces chromées, la présence de métal dans la poignée créant un couplage avec les zones de détection et inhibant la détection de présence d'un utilisateur.

Si pour certains véhicules, les fausses détections ne sont pas souhaitées, pour d'autres véhicules, les fausses détections ne sont pas tolérées.

C'est le cas, des véhicules équipés de poignées déployantes, c'est-à-dire le cas de poignées pour lesquelles la détection de la présence de l'utilisateur commande le mouvement d'une poignée motorisée qui, lorsqu'elle est au repos, est complètement intégrée dans la portière et lorsqu'elle est activée se déploie et fait saillie en dehors de la portière. Pour ce type de poignée le déploiement ou la rétractation intempestive de la poignée due à une fausse détection par les capteurs capacitifs risque de heurter ou de pincer la main de l'utilisateur.

C'est également le cas pour des véhicules équipés d'une ouverture par assistance électrique, pour lesquels la détection de déverrouillage s'accompagne non seulement du déverrouillage de la portière mais également de son ouverture. Dans ce cas, les fausses détections engendrent des ouvertures intempestives de la portière.

Et finalement, les fausses détections ne sont pas tolérables pour des véhicules équipés de la fonction de sécurité « Safe Lock », pour lesquels, la détection de verrouillage commande non seulement le verrouillage du véhicule de l'extérieur mais aussi le verrouillage du véhicule de l'intérieur (dispositif antivol). Dans ce cas, les fausses détections peuvent provoquer l'enfermement de l'utilisateur à l'intérieur du véhicule.

Pour remédier à ces inconvénients, il est connu de l'art antérieur de remplacer au moins un des capteurs capacitifs, par exemple le capteur capacitif dédié au verrouillage du véhicule, par un interrupteur mécanique de type bouton poussoir, mais l'aspect esthétique et l'ergonomie d'un bouton sur une poignée ne sont pas satisfaisants pour les utilisateurs. Par exemple, le bouton est visible de l'extérieur et n'est pas adapté aux poignées déployantes où il est recherché avant tout la discrétion concernant la présence de la poignée dans la portière.

Et l'appui sur un bouton poussoir est moins confortable pour l'utilisateur que la détection automatique d'approche de sa main vers la poignée qui ne nécessite aucun appui de sa part.

Il est aussi connu, par exemple dans le document FR 3 038 642 A1, de remplacer au moins un des capteurs capacitifs par un capteur inductif comprenant une cible métallique qui se déplace vers une bobine du capteur lors de l'appui de l'utilisateur sur la zone de verrouillage ou de déverrouillage. La variation d'inductance de la bobine du capteur inductif, liée à l'approche de la cible permettent de valider la détection d'intention de verrouillage ou de déverrouillage de l'utilisateur. Cependant, ce type de capteur présente également un inconvénient, car il est sensible aux vibrations du véhicule, et aux claquements de portières lorsque celles-ci sont fermées brutalement. Il est donc également susceptible d'engendrer de fausses détections.

La présente invention permet de résoudre ces inconvénients et propose un procédé de détection selon la revendication 1 et un dispositif d'intention de verrouillage et/ou de déverrouillage d'une poignée de portière de véhicule automobile selon la revendication 2 ne présentant pas les inconvénients de l'art antérieur.

Des modes de réalisation préférés sont définis dans les revendications dépendantes.

L'invention s'applique à tout véhicule automobile comprenant un dispositif selon l'une quelconque des caractéristiques énumérées ci-dessus.

D'autres caractéristiques et avantages de l'invention apparaîtront à la lecture de la description qui va suivre et à l'examen des dessins annexés dans lesquels :

- **la figure 1**, expliquée précédemment, représente schématiquement le dispositif de détection D selon l'art antérieur intégré dans une poignée 10 de portière P de véhicule automobile,
- **la figure 2** représente schématiquement le dispositif de détection D' selon l'invention, intégré dans une poignée 10 de portière P de véhicule automobile, selon un premier mode de réalisation
- **la figure 3**, représente un schéma électronique du dispositif de détection D' comprenant une horloge, des moyens de mémorisation d'instants, des moyens de calcul de durée, et des moyens de comparaison de durée, selon un deuxième mode de réalisation de l'invention,
- **la figure 4** représente schématiquement la variation de la fréquence de résonance F du dispositif de détection D' selon le temps t, lors de l'approche de l'utilisateur vers la poignée puis du contact de l'utilisateur avec la poignée,
- **la figure 5** est un logigramme, représentant le procédé de détection selon l'invention.

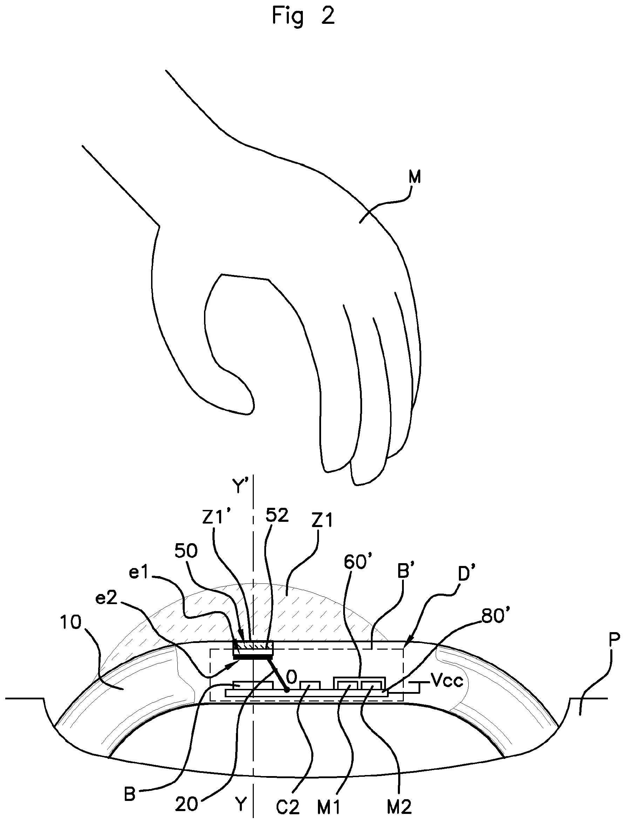

Le dispositif de détection D' selon l'invention est illustré à la **figure 2**.

Ledit dispositif de détection D' a la forme d'un boitier intégré B' dans la poignée 10 et comprend, comme dans l'art antérieur, un circuit imprimé 80 et au moins un moyen de détection d'approche et contact de la main de l'utilisateur sur la poignée 10 et une source de tension Vcc.

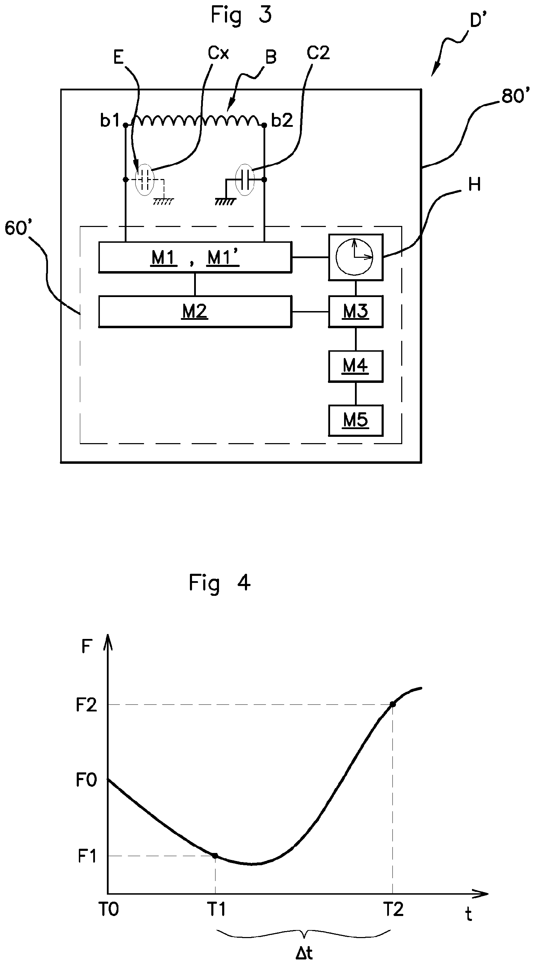

Cependant, contrairement à l'art antérieur, dans lequel le moyen de détection d'approche et de contact était constitué d'un capteur capacitif (électrodes de verrouillage E1 ou de déverrouillage E2), l'invention propose ici que ledit moyen de détection de contact (cf. **figure 3**) comprenne en outre un capteur inductif, comprenant une bobine B et une cible métallique amagnétique qui n'est autre qu'une électrode E de détection capacitive d'approche de la main M de l'utilisateur, c'est-à-dire une électrode de verrouillage ou de déverrouillage.

Selon l'invention, le dispositif de détection D' d'intention de verrouillage ou de déverrouillage d'une portière P de véhicule automobile (cf. **figure 2**) comprend donc :

- une bobine B,
- une électrode mobile E, dont une première face e1 est orientée vers la poignée 10, et une deuxième face e2 est située en vis-à-vis de la bobine B, selon un axe Y-Y', et qui est apte à se déplacer d'une position de repos à proximité de la poignée 10 vers une position finale à proximité de la bobine B, sous l'effet d'un contact de l'utilisateur sur la poignée 10,
- une capacité C2 reliée à la masse.

La bobine B consiste en un enroulement de fil de cuivre, par exemple imprimé sur le circuit imprimé 80. L'électrode mobile E consiste en une plaque en métal conducteur, par exemple en aluminium. L'électrode E étant mobile, elle n'est pas imprimée sur le circuit imprimé 80, ladite électrode mobile E est une plaque en aluminium rigide, située à distance dudit circuit imprimé 80 et reliée électriquement au circuit imprimé 80 par une liaison flexible conductrice 20 présentant un point de pivot 0.

Une première face e1 de l'électrode mobile E est orientée vers la poignée 10, plus précisément, l'électrode mobile E est, dans une position de repos, située à proximité de la poignée 10, préférentiellement au contact d'une face interne du boitier B', lui-même inséré dans la poignée 10.

Une deuxième face e2 de l'électrode mobile E est située en vis-à-vis de la bobine B, selon l'axe Y-Y'. L'électrode mobile E se déplace, lors du contact de l'utilisateur sur la poignée 10, selon l'axe Y-Y', de sa position de repos située à proximité de la poignée 10 vers une position finale, située prés de la bobine B et se rapproche ainsi de ladite bobine B.

L'électrode mobile E en aluminium et la bobine B forment ainsi un capteur inductif, dont la cible mobile est constituée par l'électrode mobile E.

L'appui de la main M de l'utilisateur sur la poignée 10, par exemple, selon l'axe Y-Y' (cf. **figure 2**) déforme localement ladite poignée, ainsi que le boitier B'. La déformation engendre le déplacement selon ledit axe Y-Y' de l'électrode mobile E, par le pivotement de la liaison flexible conductrice 20 autour du point de pivot 0, ce qui rapproche ainsi l'électrode mobile E de la bobine B.

Dans ce but, préférentiellement, le boitier B' comprend une première partie 52 déformable élastiquement selon l'axe Y-Y', comprenant une zone de contact 50 avec la poignée 10 et l'électrode mobile E est en contact avec la première partie 52 du boitier B'.

Afin d'accentuer la déformation de la poignée 10 et allonger le déplacement de l'électrode mobile E vers la bobine B, la poignée 10 comprend également une zone déformable élastiquement Z1' alignée selon l'axe Y-Y' avec la zone de contact 50, et de dimensions supérieures ou égales à celles-ci.

Bien sûr, avantageusement, la zone déformable élastiquement Z1' de la poignée se trouve dans la zone de verrouillage ou de déverrouillage de la poignée 10. Ici comme illustré à la **figure 2**, l'invention est décrite, en considérant que la zone déformable élastiquement Z1' est située dans la zone de verrouillage Z1. Le dispositif de détection D' de l'invention est donc disposé en regard de la zone de verrouillage Z1 de façon à détecter l'intention de verrouiller le véhicule (cf. **figure 2**).

Bien sûr, l'invention s'applique également à la détection d'intention de déverrouiller le véhicule, et le dispositif de détection D' peut être positionné en regard de la zone de déverrouillage Z2 (non représenté à la **figure 2**).

L'électrode mobile E génère, à sa borne (l'autre borne étant « virtuelle », constituée par la main M de l'utilisateur, reliée à la masse), en présence d'une deuxième électrode à proximité, en l'occurrence en présence de la main M de l'utilisateur reliée à la masse, une capacité Cx variable, qui est fonction de la distance séparant ladite électrode mobile E de la main M de l'utilisateur.

La mesure de la variation ΔCx de la capacité Cx permet donc de détecter l'approche de la main M vers la poignée et de valider une intention de verrouillage ou de déverrouillage. Cependant, ce procédé de l'art antérieur, basé sur la détection capacitive uniquement, présente des inconvénients comme décrits précédemment.

Comme illustré à la **figure 3**, l'électrode mobile E, la bobine B, et la capacité C2 sont connectées entre eux de manière à former un circuit oscillant résonant du type « LC », ou L représente l'inductance du circuit oscillant résonant (en l'occurrence ici l'inductance de la bobine B) et C est la capacité du circuit résonant. A la **figure 3**, une première borne b1 de la bobine B est reliée à l'électrode mobile E, et une deuxième borne b2 de la bobine B est reliée à la capacité C2.

Le circuit oscillant résonant possède une fréquence de résonance F intrinsèque. Comme cela est décrit ci-dessous, la fréquence de résonance F varie en fonction de la variation de capacité ΔCx de l'électrode mobile E, et en fonction de la position de l'électrode mobile E par rapport à la bobine B. Ladite fréquence de résonance F diminue lorsque l'utilisateur s'approche de la poignée 10 et augmente lorsque l'utilisateur agrippe la poignée et que l'électrode E se déplace vers la bobine B dans sa position finale.

Selon le circuit oscillant résonant représenté à la **figure 3**, la capacité C du circuit oscillant résonant varie selon la variation $\Delta Cx$ de la capacité $Cx$ et est donnée par :

$$C = \frac{(Cx+\Delta Cx)\times C2}{(Cx+\Delta Cx)+C2}$$

Avec :

Cx : capacité de l'électrode mobile E,
$\Delta Cx$ : variation de la capacité $Cx$ de l'électrode mobile E,
C2 : valeur de la capacité C2.

Le dispositif de détection D', selon l'invention, comprend également :

- des moyens d'oscillation de fréquence M1 du circuit oscillant résonant et des moyens de mesure M1' d'une fréquence de résonance F dudit circuit oscillant résonant,
- des moyens de comparaison de la fréquence M2 de résonance F ainsi mesurée à des seuils, plus particulièrement à un premier seuil F1 et à un deuxième seuil F2,
- des moyens de contrôle 60' des moyens d'oscillation de fréquence M1, des moyens de mesure M1' et des moyens de comparaison de la fréquence M2.

Pour mettre en œuvre le procédé de détection, le dispositif de détection D' comprend en outre :

- une horloge H,
- des moyens de mémorisation d'instants M3, plus particulièrement, de mémorisation d'un premier instant T1 de passage de la fréquence de résonance F en dessous du premier seuil F1 et de mémorisation d'un deuxième instant T2 de passage de la fréquence de résonance F au dessus du deuxième seuil F2,
- des moyens de calcul M4 d'une durée $\Delta t$ entre le premier instant T1 et le deuxième instant T2 et
- des moyens de comparaison M5 entre ladite durée $\Delta t$ et une durée prédéterminée $\Delta t_{ref}$.

L'horloge H, les moyens de mémorisation d'instants M3, les moyens de calcul M4 de durée et les moyens de comparaison M5 de la dite durée peuvent se présenter sous forme logicielle, intégrés dans les moyens de contrôle 60' (microcontrôleur).

Les moyens d'oscillation de fréquence M1 et de mesure M1' de la fréquence de résonance peuvent être compris dans un convertisseur inductance numérique.

Les moyens de comparaison de la fréquence M2 se présentent sous forme de logiciel, pouvant être compris dans les moyens de contrôle 60', par exemple dans un microcontrôleur.

Les moyens d'oscillation de fréquence M1, les moyens de mesure M1', les moyens de comparaison de la fréquence M2 peuvent être intégrés dans le circuit imprimé 80.

La fréquence de résonance F du circuit résonant oscillant est donnée par l'équation suivante :

$$F = \frac{1}{2\times\pi\times\sqrt{(L\times C)}}$$

Soit :

$$F = \frac{1}{2\times\pi\times\sqrt{\left(L\times\frac{(Cx+\Delta Cx)\times C2}{(Cx+\Delta Cx)+C2}\right)}}$$

Avec :

L : inductance de la bobine B
$\Pi$ : constante égale à 3,14,
Cx : capacité de l'électrode mobile E,
$\Delta Cx$ : variation de la capacité $Cx$ de l'électrode mobile E,
C2 : valeur de la capacité C2.

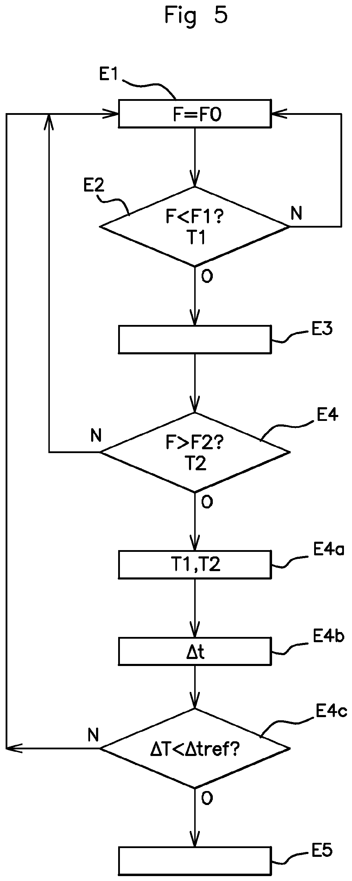

Le procédé de détection d'intention, par un utilisateur, de verrouillage ou de déverrouillage d'une portière de véhicule automobile, selon l'invention est illustré à la **figure 5** et est décrit ci-dessous.

Dans un premier temps (étape E1), les moyens d'oscillation de fréquence M1 excitent le circuit oscillant résonant, constitué de l'électrode mobile E, de la bobine B et de la capacité C2. En l'absence de la main M à proximité de la poignée (c'est-à-dire à proximité du dispositif de détection D'), la valeur de la capacité à la borne de l'électrode mobile E, est égale à Cx, et la fréquence de résonance F du circuit résonant, mesurée par les moyens de mesure M1', est égale à :

$$F0 = \frac{1}{2\times\pi\times\sqrt{\left(L\times\frac{Cx\times C2}{Cx+C2}\right)}}$$

Lorsque la main M de l'utilisateur s'approche de la poignée 10, la valeur de la capacité aux bornes de l'électrode mobile E augmente progressivement de $\Delta Cx$, et par conséquent la fréquence de résonance F diminue et vaut :

$$F = \frac{1}{2\times\pi\times\sqrt{\left(L\times\frac{(Cx+\Delta Cx)\times C2}{(Cx+\Delta Cx)+C2}\right)}}$$

La fréquence de résonance F atteint un minimum lorsque la main M de l'utilisateur touche la poignée 10, correspondant à la variation maximale $\Delta Cxmax$ de la capacité $Cx$ de l'électrode mobile E.

$$F = \frac{1}{2 \times \pi \times \sqrt{\left(L \times \frac{(Cx + \Delta Cxmax) \times C2}{(Cx + \Delta Cxmax) + C2}\right)}}$$

Les moyens de comparaison de la fréquence M2 comparent la fréquence de résonance ainsi mesurée à un premier seuil F1 (étape E2). Lorsque la fréquence de résonance F passe en dessous un premier seuil F1, à un premier instant T1 (cf. **figure 4**), alors la détection d'approche de la main de l'utilisateur vers la poignée 10 est validée (étape E3) mais la détection d'intention de verrouiller ni de déverrouiller la portière n'est pas validée, contrairement à l'art antérieur..

Puis dans un deuxième temps, l'utilisateur agrippe la poignée 10. L'appui de la main M sur la poignée 10 déforme localement ladite poignée 10 (sur la zone déformable élastiquement Z1') ainsi que la première partie 52 du boitier B' et provoque le déplacement de l'électrode mobile E vers la bobine B, selon l'axe Y-Y', comme expliqué précédemment.

L'électrode mobile E ayant une fonction de cible vis-à-vis de la bobine B, lorsque l'électrode mobile E se rapproche de la bobine B, l'inductance L de la bobine diminue, jusqu'à atteindre une valeur minimum Lmin. La fréquence de résonance F du circuit résonant augmente alors et vaut :

$$F = \frac{1}{2 \times \pi \times \sqrt{\left(Lmin \times \frac{(Cx + \Delta Cx) \times C2}{(Cx + \Delta Cx) + C2}\right)}}$$

Les moyens de comparaison de la fréquence M2 comparent la fréquence de résonance ainsi mesurée à un deuxième seuil F2 (étape E4).

SI la fréquence de résonance F passe en dessous du deuxième seuil F2 à un deuxième instant T2, alors la détection de contact est validée, mais la détection d'intention de verrouiller ou de déverrouiller n'est pas validée.

Selon l'invention, la détection d'intention de verrouiller ou de déverrouiller la portière n'est validée (étape E5) que si :

- la fréquence de résonance F passe en dessous un premier seuil F1, à un premier instant T1 et la fréquence de résonance F passe au dessus d'un deuxième seuil F2, à un deuxième instant T2, , le premier instant T1 et le deuxième instant T2 étant mémorisés (E4a), une durée $\Delta t$ entre ledit deuxième instant T2 et le premier instant T1 est calculée (E4b), et

- la durée $\Delta t$ entre le premier instant T1 et le deuxième instant T2, ainsi calculée est inférieure à une durée prédéterminée $\Delta t_{ref}$ (étape E4c).

Ingénieusement, le procédé de détection de l'invention réside donc dans l'utilisation de l'électrode mobile E comme :

- une électrode de détection d'approche de la main de l'utilisateur,
- une cible de capteur inductif, couplée à la bobine B, une fois la main posée sur la poignée 10,
- une capacité variable du circuit oscillant résonant, constitué par la bobine B, et la capacité C2.

Dans un premier temps, l'électrode mobile E ne se déplace pas et fonctionne en tant que capteur capacitif de détection d'approche de la main de l'utilisateur. Cependant, contrairement à l'art antérieur, le procédé de détection selon l'invention ne mesure pas en continu la variation de capacité $\Delta Cx$ de l'électrode mobile E, mais la fréquence de résonance F du circuit oscillant résonant, que l'électrode mobile E, constitue avec la bobine B et la capacité C2. En effet, la fréquence de résonance F varie en fonction de la variation de capacité $\Delta Cx$ de l'électrode mobile E, due à l'approche de l'utilisateur.

La capacité C2 est une capacité d'adaptation qui permet d'ajuster la fréquence du circuit oscillant résonant et permet la cohérence électrique (en étant reliée à la masse) du dit circuit.

Dans un deuxième temps, l'utilisateur appuie sur la poignée 10 et l'électrode mobile E se déplace et fonctionne en tant que cible du capteur inductif, constitué par ladite électrode E couplée à la bobine B. La mesure de la variation fréquence de résonance F du circuit oscillant résonant (due à la variation d'inductance L de la bobine) permet ici de détecter l'approche de l'électrode mobile E vers la bobine B, dans une position finale qui signifie l'appui de l'utilisateur sur la poignée 10.

Le procédé de détection de l'invention comprend donc la mesure en continu de la fréquence de résonance F du circuit oscillant résonant et la comparaison de ladite fréquence F à deux seuils successifs, un premier seuil F1, représentatif de la variation de capacité de l'électrode mobile E, due à l'approche de la main M de l'utilisateur vers la poignée 10, et un deuxième seuil F2, supérieur au premier seuil F1, représentatif de la variation d'inductance de la bobine B, due au contact de la main M de l'utilisateur sur la poignée 10. Si la valeur de la fréquence de résonance F mesurée est successivement inférieure au premier seuil F1 à un premier instant T1, puis supérieure au deuxième seuil F2 à un deuxième instant T2 et que la durée $\Delta t$ entre le premier instant T1 et le deuxième instant T2 est inférieure à une durée prédéterminée $\Delta t_{ref}$ alors la détection d'intention de verrouiller ou de déverrouiller de l'utilisateur est validée (étape E5).

Ainsi, en cas de perturbations extérieures, telles que la pluie, la neige sur la poignée 10, ou un air ambiant humide engendrant le passage de la fréquence de résonance F en dessous du premier seuil F1, la détection d'intention de verrouiller ou de déverrouiller ne sera pas validée, dans la mesure où la fréquence de résonance ne passera pas ensuite au dessus du 2ème seuil dans le délai prédéterminé $\Delta t_{ref}$

Inversement, en cas de vibrations, ou de claquement de portière, engendrant le passage de la fréquence de résonance au dessus du 2ème seuil F2, la détection d'intention de verrouiller ou de déverrouiller ne sera pas validée, dans la mesure où la fréquence de résonance ne sera pas passée préalablement en dessous d'un premier seuil F1.

Dans le cas d'une peinture métallique, la variation de capacité $\Delta Cx$ peut faire baisser la fréquence de résonance en dessous du premier seuil F1, mais une calibration du premier seuil F1 spécifique aux poignées recouvertes d'ue peinture métallique pourra remédier à ce problème. De plus en aucun cas, la fréquence de résonance F ne dépassera le deuxième seuil F2 dans la durée prédéterminée $\Delta t_{ref}$.

L'invention est particulièrement pertinente dans le cas d'un utilisateur se rapprochant de la poignée sans la toucher. Dans ce cas, la fréquence de résonance F baisse et peut être inférieure au premier seuil F1, mais en aucun cas ne dépassera dans la durée prédéterminée le deuxième seuil F2, celui-ci étant prédéterminé pour le cas où l'électrode mobile E se rapproche de la bobine B dans sa position finale.

Le procédé de détection de l'invention est donc particulièrement robuste et évite les fausses détections.

Dans le procédé de détection selon l'invention, le premier instant T1 et le deuxième instant T2 sont mémorisés, puis une durée $\Delta t$ entre ledit deuxième instant T2 et le premier instant T1 est calculée).

La durée $\Delta$ ainsi mesurée est alors comparée à une durée prédéterminée $\Delta t_{ref}$ La détection d'intention de verrouiller ou de déverrouiller n'est alors validée que si la durée $\Delta t$ n'est inférieure à la durée prédéterminée $\Delta t_{ref}$.

Le procédé de l'invention pallie aux fausses détections dues à l'approche fortuite de l'utilisateur près de la poignée 10 sans l'intention de déverrouiller ou verrouiller son véhicule. Dans ce cas, l'utilisateur s'approche de la poignée 10 suffisamment pour la fréquence de résonance F, passe en dessous du premier seuil F1, mais il n'agrippe pas la poignée, et la fréquence de résonance F ne passe pas du dessous du deuxième seuil F2 dans un délai imparti, qui est la durée prédéterminée $\Delta t_{ref}$.

La durée prédéterminée $\Delta t_{ref}$ a été mesurée au préalable et correspond à une durée maximale nécessaire à l'utilisateur pour agripper la poignée 10.

L'invention permet donc la détection d'intention par l'utilisateur de verrouiller ou de déverrouiller son véhicule de manière fiable et robuste.

## Revendications

1. Procédé de détection d'intention de verrouillage ou de déverrouillage d'une portière de véhicule automobile par un utilisateur par un dispositif de détection (D') intégré dans une poignée (10), le dispositif étant équipé au préalable :

• d'une bobine (B),
• d'une électrode mobile (E) dont une première face (e1) est orientée vers la poignée (10), et une deuxième face (e2) est située en vis-à-vis de la bobine (B), ladite électrode mobile (E) étant apte à se déplacer d'une position de repos, située à proximité de la poignée (10) vers une position finale, située à proximité de la bobine (B), sous l'effet d'un contact de l'utilisateur sur la poignée (10),
• d'une capacité (C2) reliée à la masse, l'électrode mobile (E), la bobine (B) et la capacité (C2) étant connectées entre elles afin de former un circuit résonant dont une fréquence de résonance (F) varie en fonction d'une variation de capacité de l'électrode mobile (E), et de la position de l'électrode mobile (E), ladite fréquence de résonance diminuant lorsque l'utilisateur s'approche de la poignée et augmentant lorsque l'utilisateur agrippe la poignée et que l'électrode (E) se déplace vers la position finale,
• des moyens d'oscillation de fréquence (M1) dudit circuit résonant et de mesure (M1') d'une fréquence de résonance (F) dudit circuit résonant,
• et ledit procédé comprenant :

• la mesure en continu de la fréquence de résonance (F) dudit dispositif de détection (D') et la comparaison de ladite fréquence de résonance (F) mesurée successivement à un premier seuil (F1) représentatif de l'approche de l'utilisateur et à un deuxième seuil (F2), supérieur au premier seuil (F1) représentatif du contact de l'utilisateur l'intention de verrouiller ou de déverrouiller la portière n'étant validée que si :

• la valeur de la fréquence de résonance (F) mesurée est d'abord inférieure à un premier seuil (F1), à un premier instant mesuré (T1), puis supérieure à au deuxième seuil (T2), dans un deuxième instant mesuré (T2), et
• une durée ($\Delta t$) entre le deuxième instant (T2) et le premier instant (T1) est inférieure à une durée prédéterminée ($\Delta t_{ref}$).

2. Dispositif de détection (D') d'intention de verrouillage ou de déverrouillage d'une portière de véhicule automobile par un utilisateur, ledit dispositif (D') étant intégré dans une poignée (10), alimenté par une source de tension (Vcc) et comprenant

• une bobine (B),
• une électrode mobile (E) dont une première face (e1) est orientée vers la poignée (10), et une deuxième face (e2) est située en vis-à-vis de la bobine (B), ladite électrode mobile (E) étant apte à se déplacer d'une position de repos, située à proximité de la poignée (10) vers une position finale, située à proximité de la bobine (B), sous l'effet d'un contact de l'utilisateur sur la poignée (10),

• une capacité (C2) reliée à la masse, l'électrode mobile (E), la bobine (B) et la capacité (C2) étant connectées entre elles afin de former un circuit résonant dont une fréquence de résonance (F) varie en fonction d'une variation de capacité de l'électrode mobile (E), et de la position de l'électrode mobile (E), ladite fréquence de résonance diminuant lorsque l'utilisateur s'approche de la poignée et augmentant lorsque l'utilisateur agrippe la poignée et que l'électrode (E) se déplace vers la position finale,

• des moyens d'oscillation de fréquence (M1) dudit circuit résonant et de mesure (M1') d'une fréquence de résonance (F) dudit circuit résonant,

• des moyens de comparaison de la fréquence (M2) de résonance successivement à un premier seuil (F1) représentatif de l'approche de l'utilisateur et à un deuxième seuil (F2), supérieur au premier seuil (F1) représentatif du contact de l'utilisateur,

• des moyens de contrôle (60') des moyens d'oscillation de fréquence (M1), des moyens de mesure (M1') et des moyens de comparaison de la fréquence (M2).

• une horloge (H),

• des moyens de mémorisation d'instants (M3), apte à mémoriser le premier instant (T1) de passage de la fréquence de résonance (F) en dessous d'un premier seuil (F1) et un deuxième instant (T2) de passage de la fréquence de résonance (F) au dessus d'un deuxième seuil (F2),

• des moyens de calcul (M4) d'une durée ($\Delta$t) entre le premier instant (T1) et le deuxième instant (T2),

• des moyens de comparaison (M5) de ladite durée ($\Delta$t) avec une durée prédéterminée ($\Delta t_{ref}$), l'intention de verrouiller ou de déverrouiller la portière n'étant validée que si la durée ($\Delta$t) entre le deuxième instant (T2) et le premier instant (T1) est inférieure à la durée prédéterminée ($\Delta$tref).

3. Dispositif de détection (D'), selon la revendication précédente, **caractérisé en qu'**une première borne (b1) de la bobine (B) est connectée à l'électrode mobile (E) et une deuxième borne (b2) de la bobine (B) est connectée à la capacité (C2).

4. Dispositif de détection (D'), selon la revendication 2 ou 3, **caractérisé en ce que** la bobine (B) et la capacité (C2) sont situées sur un circuit imprimé (80) et **en ce que** l'électrode mobile (E) est apte à se déplacer par l'intermédiaire d'une liaison flexible conductrice (20) reliant électriquement ladite électrode mobile (E) au circuit imprimé (80) et présentant un point de pivot (0).

5. Dispositif de détection (D'), selon l'une quelconque des revendications 2 à 4, **caractérisé en ce que** les moyens d'oscillation de fréquence (M1), les moyens de mesure (M1') et les moyens de comparaison de fréquence (M2) sont situés sur le circuit imprimé (80).

6. Dispositif de détection (D'), selon l'une quelconque des revendications 2 à 5, **caractérisé en ce que** le dit dispositif est intégré dans un boitier (B') comprenant une première partie (52), déformable élastiquement selon un axe prédéterminé (Y-Y'), présentant une zone de contact (50) avec la poignée (10), et **en ce que** l'électrode mobile (E) est, apte à dans une position de repos, en contact avec la première partie (52), et dans une position finale à proximité de la bobine (B)

7. Poignée (10) de portière de véhicule automobile, **caractérisée en ce qu'**elle comprend un dispositif (D') selon l'une quelconque des revendications 2 à 6.

8. Poignée (10) selon la revendication 7, **caractérisée en ce qu'**elle comprend au moins une zone déformable élastiquement (Z1') alignée selon l'axe prédéterminé (Y-Y') avec la zone de contact (50), de dimensions supérieures ou égales aux dimensions de la zone de contact (50).

9. Véhicule automobile **caractérisé en ce qu'**il comprend un dispositif (D') selon l'une quelconque des revendications 2 à 6.

**Patentansprüche**

1. Verfahren zur Erfassung einer Absicht des Verriegelns oder Entriegelns einer Fahrzeugtür durch einen Benutzer durch eine in einen Türgriff (10) integrierte Erfassungsvorrichtung (D'),
wobei die Vorrichtung vorab ausgestattet wird mit:

• einer Spule (B),
• einer beweglichen Elektrode (E), von der eine erste Seite (e1) zum Türgriff (10) ausgerichtet ist und eine zweite Seite (e2) sich gegenüber der Spule (B) befindet, wobei die bewegliche Elektrode (E) fähig ist, sich unter der Wirkung eines Kontakts des Benutzers mit dem Türgriff (10) von einer Ruhestellung, die sich in der Nähe des Türgriffs (10) befindet, in eine Endstellung zu verschieben, die sich in der Nähe der Spule (B) befindet,

• einer mit Masse verbundenen Kapazität (C2), wobei die bewegliche Elektrode (E), die Spule (B) und die Kapazität (C2) miteinander verbunden sind, um einen Resonanzkreis zu bilden, von dem eine Resonanzfrequenz (F) abhängig von einer Kapazitätsänderung der beweglichen Elektrode (E) und der Stellung der beweglichen Elektrode (E) variiert, wobei die Resonanzfrequenz abnimmt, wenn der Benutzer sich dem Türgriff nähert, und zunimmt, wenn der Benutzer den Türgriff ergreift und die Elektrode (E) sich zur Endstellung hin verschiebt,

• Einrichtungen zur Frequenzschwingung (M1) des Resonanzkreises und zur Messung (M1') einer Resonanzfrequenz (F) des Resonanzkreises,

wobei das Verfahren enthält:

• die fortlaufende Messung der Resonanzfrequenz (F) der Erfassungsvorrichtung (D') und den Vergleich der gemessenen Resonanzfrequenz (F) nacheinander mit einer für die Annäherung des Benutzers repräsentativen ersten Schwelle (F1) und mit einer für den Kontakt des Benutzers repräsentativen zweiten Schwelle (F2), die höher ist als die erste Schwelle (F1), wobei die Absicht des Verriegelns oder Entriegelns der Tür nur validiert wird, wenn:

• der Wert der gemessenen Resonanzfrequenz (F) zunächst zu einem ersten gemessenen Zeitpunkt (T1) niedriger als eine erste Schwelle (F1), dann zu einem zweiten gemessenen Zeitpunkt (T2) höher als die zweite Schwelle (T2) ist, und
• ein Zeitraum ($\Delta t$) zwischen dem zweiten Zeitpunkt (T2) und dem ersten Zeitpunkt (T1) geringer ist als ein vorbestimmter Zeitraum ($\Delta t_{ref}$).

2. Erfassungsvorrichtung (D') einer Absicht des Verriegelns oder Entriegelns einer Fahrzeugtür durch einen Benutzer, wobei die Vorrichtung (D') in einen Türgriff (10) integriert ist, gespeist von einer Spannungsquelle (Vcc) und enthaltend:

• eine Spule (B),
• eine bewegliche Elektrode (E), von der eine erste Seite (e1) zum Türgriff (10) ausgerichtet ist und eine zweite Seite (e2) sich gegenüber der Spule (B) befindet, wobei die bewegliche Elektrode (E) fähig ist, sich unter der Wirkung eines Kontakts des Benutzers mit dem Türgriff (10) von einer Ruhestellung, die sich in der Nähe des Türgriffs (10) befindet, in eine Endstellung zu verschieben, die sich in der Nähe der Spule (B) befindet,

• eine mit Masse verbundenen Kapazität (C2), wobei die bewegliche Elektrode (E), die Spule (B) und die Kapazität (C2) miteinander verbunden sind, um einen Resonanzkreis zu bilden, von dem eine Resonanzfrequenz (F) abhängig von einer Kapazitätsänderung der beweglichen Elektrode (E) und von der Stellung der beweglichen Elektrode (E) variiert, wobei die Resonanzfrequenz abnimmt, wenn der Benutzer sich dem Türgriff nähert, und zunimmt, wenn der Benutzer den Türgriff ergreift und die Elektrode (E) sich zur Endstellung hin verschiebt,

• Einrichtungen zur Frequenzschwingung (M1) des Resonanzkreises und zur Messung (M1') einer Resonanzfrequenz (F) des Resonanzkreises,

• Einrichtungen zum Vergleich der Resonanzfrequenz (M2) nacheinander mit einer für die Annäherung des Benutzers repräsentativen ersten Schwelle (F1) und mit einer für den Kontakt des Benutzers repräsentativen zweiten Schwelle (F2), die höher ist als die erste Schwelle (F1),

• Steuereinrichtungen (60') der Einrichtungen zur Frequenzschwingung (M1), der Messeinrichtungen (M1') und der Vergleichseinrichtungen der Frequenz (M2),

• einen Taktgeber (H),

• Einrichtungen zum Speichern von Zeitpunkten (M3), die den ersten Zeitpunkt (T1) des Übergangs der Resonanzfrequenz (F) unter eine erste Schwelle (F1) und einen zweiten Zeitpunkt (T2) des Übergangs der Resonanzfrequenz (F) über eine zweite Schwelle (F2) speichern können,

• Einrichtungen zur Berechnung (M4) eines Zeitraums ($\Delta t$) zwischen dem ersten Zeitpunkt (T1) und dem zweiten Zeitpunkt (T2),

• Einrichtungen zum Vergleich (M5) des Zeitraums ($\Delta t$) mit einem vorbestimmten Zeitraum ($\Delta t_{ref}$), wobei die Absicht, die Tür zu verriegeln oder zu entriegeln nur validiert wird, wenn der Zeitraum ($\Delta t$) zwischen dem zweiten Zeitpunkt (T2) und dem ersten Zeitpunkt (T1) geringer ist als der vorbestimmte Zeitraum ($\Delta t_{ref}$).

3. Erfassungsvorrichtung (D') nach dem vorhergehenden Anspruch, **dadurch gekennzeichnet, dass** eine erste Klemme (b1) der Spule (B) mit der beweglichen Elektrode (E) und eine zweite Klemme (b2) der Spule (B) mit der Kapazität (C2) verbunden ist.

4. Erfassungsvorrichtung (D') nach Anspruch 2 oder 3, **dadurch gekennzeichnet, dass** die Spule (B) und die Kapazität (C2) sich auf einer Leiterplatte (80) befinden, und dass die bewegliche Elektrode (E) fähig ist, sich mittels einer leitenden flexiblen Verbindung (20) zu verschieben, die die bewegliche Elektrode (E) elektrisch mit der Leiterplatte (80) verbindet und einen Gelenkpunkt (0) aufweist.

5. Erfassungsvorrichtung (D') nach einem der Ansprüche 2 bis 4, **dadurch gekennzeichnet, dass** die Einrichtungen zur Frequenzschwingung (M1), die Messeinrichtungen (M1') und die Frequenzvergleichseinrichtungen (M2) sich auf der Leiterplatte (80) befinden.

6. Erfassungsvorrichtung (D') nach einem der Ansprüche 2 bis 5, **dadurch gekennzeichnet, dass** die Vorrichtung in ein Gehäuse (B') integriert ist, das einen gemäß einer vorbestimmten Achse (Y-Y') elastisch verformbaren ersten Teil (52) enthält, der eine Kontaktzone (50) mit dem Türgriff (10) aufweist, und dass die bewegliche Elektrode (E) fähig ist, in einer Ruhestellung in Kontakt mit dem ersten Teil (52) zu treten, und in einer Endstellung in der Nähe der Spule (B) ist.

7. Türgriff (10) einer Fahrzeugtür, **dadurch gekennzeichnet, dass** er eine Vorrichtung (D') nach einem der Ansprüche 2 bis 6 enthält.

8. Türgriff (10) nach Anspruch 7, **dadurch gekennzeichnet, dass** er mindestens eine gemäß der vorbestimmten Achse (Y-Y') mit der Kontaktzone (50) ausgerichtete elastisch verformbare Zone (Z1') enthält, die Abmessungen größer als die oder gleich den Abmessungen der Kontaktzone (50) hat.

9. Kraftfahrzeug, **dadurch gekennzeichnet, dass** es eine Vorrichtung (D') nach einem der Ansprüche 2 bis 6 enthält.

**Claims**

1. Method for detecting the intention of a user to lock or unlock a motor-vehicle door with a detection device (D') integrated into a handle (10), the device being equipped beforehand with:

   • a coil (B),
   • a movable electrode (E) a first face (e1) of which is oriented toward the handle (10), and a second face (e2) of which is located facing the coil (B), said movable electrode (E) being able to move from a rest position, located in proximity to the handle (10), to a final position, located in proximity to the coil (B), under the effect of a contact of the user on the handle (10),
   • a capacitor (C2) connected to ground, the movable electrode (E), the coil (B) and the capacitor (C2) being connected together in order to form a resonant circuit a resonant frequency (F) of which varies as a function of a variation in the capacitance of the movable electrode (E), and of the position of the movable electrode (E), said resonant frequency decreasing when the user approaches the handle and increasing when the user grips the handle and the electrode (E) moves to the final position,
• means (M1) for oscillating the frequency of said resonant circuit and means (M1') for measuring a resonant frequency (F) of said resonant circuit,
• said method comprising:

   • continuously measuring the resonant frequency (F) of said detection device (D') and successively comparing said measured resonant frequency (F) to a first threshold (F1) representative of the approach of the user and to a second threshold (F2), higher than the first threshold (F1), representative of the contact of the user, the intention to lock or unlock the door being validated only if:

      • the value of the measured resonant frequency (F) is firstly lower than a first threshold (F1), at a first measured time (T1), then higher than the second threshold (T2), at a second measured time (T2), and
      • a duration ($\Delta t$) between the second time (T2) and the first time (T1) is shorter than a preset duration ($\Delta t_{ref}$).

2. Device (D') for detecting the intention of a user to lock or unlock a motor-vehicle door, said device (D') being integrated into a handle (10) and powered by a voltage source (Vcc), and comprising:

   • a coil (B),
   • a movable electrode (E) a first face (e1) of which is oriented toward the handle (10), and a second face (e2) of which is located facing the coil (B), said movable electrode (E) being able to move from a rest position, located in proximity to the handle (10), to a final position, located in proximity to the coil (B), under the effect of a contact of the user on the handle (10),
   • a capacitor (C2) connected to ground, the movable electrode (E), the coil (B) and the capacitor (C2) being connected together in order to form a resonant circuit a resonant frequency (F) of which varies as a function of a variation in the capacitance of the movable electrode (E), and of the position of the movable electrode (E), said resonant frequency decreasing when the user approaches the handle and increasing when the user grips the handle and the electrode (E) moves to the final position,
   • means (M1) for oscillating the frequency of said resonant circuit and means (M1') for measuring a resonant frequency (F) of said resonant circuit,
• means (M2) for successively comparing the resonant frequency to a first threshold (F1) representative of the approach of the user and to a second threshold (F2), higher than the first threshold (F1), representative of the contact of the user,
• means (60') for controlling the frequency-oscillating means (M1), the measuring means (M1') and the frequency-comparing means (M2),
• a clock (H),
• means (M3) for storing times in memory, said means being able to store the first time (T1) of passage of the resonant frequency (F) below a first threshold (F1) and a second time (T2) of passage of the resonant frequency (F) above a second threshold (F2),
• means (M4) for computing a duration ($\Delta t$) between the first time (T1) and the second time (T2),
• means (M5) for comparing said duration ($\Delta t$) with a preset duration ($\Delta t_{ref}$), the intention to lock or unlock the door being validated only if the duration ($\Delta t$) between the second time (T2) and the first time (T1) is shorter than the preset duration ($\Delta t_{ref}$).

3. Detection device (D') according to the preceding claim, **characterized in that** a first terminal (b1) of the coil (B) is connected to the movable electrode (E) and a second terminal (b2) of the coil (B) is connected to the capacitor (C2).

4. Detection device (D') according to Claim 2 or 3, **characterized in that** the coil (B) and the capacitor (C2) are located on a printed circuit board (80) and **in that** the movable electrode (E) is able to move by way of a conductive flexible link (20) electrically connecting said movable electrode (E) to the printed circuit board (80) and having a pivot point (0).

5. Detection device (D') according to any one of Claims 2 to 4, **characterized in that** the frequency-oscillating means (M1), the measuring means (M1') and the frequency-comparing means (M2) are located on the printed circuit board (80).

6. Detection device (D') according to any one of Claims 2 to 5, **characterized in that** said device is integrated into a casing (B') comprising a first portion (52), which is elastically deformable along a preset axis (Y-Y'), having a zone of contact (50) with the handle (10), and **in that** the movable electrode (E) is, in a rest position, able to make contact with the first portion (52), and, in a final position, is in proximity to the coil (B).

7. Motor-vehicle door handle (10), **characterized in that** it comprises a device (D') according to any one of Claims 2 to 6.

8. Handle (10) according to Claim 7, **characterized in that** it comprises at least one elastically deformable zone (Z1') aligned along the preset axis (Y-Y') with the zone of contact (50), of dimensions larger than or equal to the dimensions of the zone of contact (50).

9. Motor vehicle, **characterized in that** it comprises a device (D') according to any one of Claims 2 to 6.

Fig 1

# Fig 2

## Fig 3

## Fig 4

## Fig 5

```
                              E1
                               ⌇
                    ┌──────────────────────┐
              ┌────→│        F=F0          │←────┐
              │     └──────────────────────┘     │
              │                 │                 │
              │                 ▼                 │
     E2                     ╱───────╲             │
      ⌇                    ╱         ╲            │
      └───────────────────╱  F<F1?    ╲    N      │
                          ╲   T1      ╱───────────┘
                           ╲         ╱
                            ╲───────╱
                               │ O
                               ▼
                    ┌──────────────────────┐
                    │                      │──── E3
                    └──────────────────────┘
                               │
                               ▼
                           ╱───────╲              E4
              N           ╱         ╲             ⌇
      ┌──────────────────╱  F>F2?    ╲────────────
      │                  ╲   T2      ╱
      │                   ╲         ╱
      │                    ╲───────╱
      │                       │ O
      │                       ▼
      │            ┌──────────────────────┐
      │            │        T1,T2         │──── E4a
      │            └──────────────────────┘
      │                       │
      │                       ▼
      │            ┌──────────────────────┐
      │            │         Δt           │──── E4b
      │            └──────────────────────┘
      │                       │
      │                       ▼
      │                   ╱───────╲            E4c
      │      N           ╱         ╲           ⌇
      ←─────────────────╱ ΔT<Δtref? ╲──────────
                        ╲           ╱
                         ╲         ╱
                          ╲───────╱
                             │ O
                             ▼
                  ┌──────────────────────┐
                  │                      │──── E5
                  └──────────────────────┘
```

## RÉFÉRENCES CITÉES DANS LA DESCRIPTION

**Documents brevets cités dans la description**

- FR 3038642 A1